# EUROPEAN PATENT SPECIFICATION

(11) **EP 1 174 965 B1**
(45) Date of publication and mention of the grant of the patent: **18.12.2002**
(21) Application number: 00109570.2
(22) Date of filing: 04.05.2000
(51) Int. Cl.: H01S 3/038, H01S 3/225

(54) **An electrode material for a gas discharge laser and gas discharge laser**
Elektrodenmaterial für einen Gasentladungslaser und Gaslaser
Matériau d'électrode pour laser à gaz à décharge et laser à gaz

(43) Date of publication of application: 23.01.2002
(73) Proprietor: TuiLaser AG, 82110 Germering (DE)
(72) Inventor: Görtler, Andreas, Dr., 86947 Weil/Schwabhausen (DE); Hohla, Alexander, 80798 München (DE)
(74) Representative: Rösler, Uwe, Dipl.-Phys.

(56) References cited:
- DE-A- 3 817 145
- US-A- 5 407 492
- US-A- 5 923 693
- PATENT ABSTRACTS OF JAPAN vol. 1995, no. 11, 26 December 1995 (1995-12-26) -& JP 07 226550 A (MITSUBISHI ELECTRIC CORP), 22 August 1995 (1995-08-22)
- PATENT ABSTRACTS OF JAPAN vol. 015, no. 147 (E-1055), 12 April 1991 (1991-04-12) -& JP 03 022578 A (MATSUSHITA ELECTRIC IND CO LTD), 30 January 1991 (1991-01-30)
- PATENT ABSTRACTS OF JAPAN vol. 010, no. 259 (E-434), 4 September 1986 (1986-09-04) -& JP 61 084882 A (MATSUSHITA ELECTRIC IND CO LTD), 30 April 1986 (1986-04-30)

## Description

### BACKGROUND OF THE INVENTION

The invention relates to electrode material for laser gas discharge electrodes.

Lasers have recently been applied to a large variety of technical areas, such as optical measurement techniques, material processing, medicine, biology, etc.

Thus, there is great demand for providing near diffraction limited laser, i.e. laser-generating laser beams with short wavelength light, thereby making it possible to form smaller features with the laser.

It has been acknowledged that a TEA laser, such as an excimer laser, which is for example disclosed in US 5,771,258, serves well as a laser capable of generating short wavelength coherent light waves.

The excimer laser described in US 5,771,258 is a krypton fluoride laser, operating in a pulsed mode. Pulsing is required to provide gas (usually krypton fluoride gas as a laser gas and helium gas as a buffer gas) within a discharge region of the laser for a sufficient time in order to return to its initial thermal state. In the discharge region (discharge gap), which is defined by a high voltage electrode and a ground electrode being placed apart from each other, a pulsed high voltage occurs, thereby initializing emissions of photons which form the laser beam.

The laser beam is emitted along the extending ground electrode in the longitudinal direction of the laser tube. The laser beam leaves the tube through a window of the tube. Usually, one window is provided at each end of the tube.

Furthermore, mirrors are provided in the tube in order to generate a standing wave in the discharge region, thereby increasing the amount of photons being emitted. A first mirror usually has a light reflection characteristic of 100%, i.e. the light impinging on the first mirror is completely reflected therefrom. A second mirror is used to decouple light partially impinging thereon.

Unfortunately, there is a problem with impurities in the tube, for example dust, which foul especially the optical elements within the tube, for example the windows and mirrors in the tube mentioned above. In addition, these dust particles float in the gas and therefore in the resonating path of the laser light in the gas discharge gap, therefore lowering the output power of the laser significantly due to scattering of the resonating laser light in the gas discharge gap.

One major source of dust is erosion of the electrodes of the gas discharge laser. Since during operation of the laser a gas discharge resulting in plasma is present near the electrodes which apply a high voltage to the gas, erosion occurs at the electrodes, namely by the gas discharge, but also due to the intense laser light and intense laser gas to which the electrodes are subjected.

Ersosion of the electrodes of the gas discharge laser can lead to the generation of so-called spikes. That is, small elevations on the surface of the electrodes are generated due to the high temperatures of up to 6000°C during laser operation and also due to the electric field between the pair of electrodes. Thereby a small portion of the electrode material thereby melts and recrystalizes directly on the surface of the electrodes.

These spikes can lead to distortion of the electric field between the pair of electrodes and thus conribute to reduction of the performance of the gas discharge laser. Further, these spikes can cause blow effects which can also reduce the performance of the gas discharge laser. Moreover, the blow effects lead to an arbitrary intermittant operating of the gas discharge laser.

Furthermore, the electrode material and the erosion products react chemically with the laser gas. The electrode erosion products become available either as particles or, if the laser gas contains halogens as volatile metal halides. Particles cause deposits of dust, something which is particularly undesirable in conjunction with the laser optics. Volatile metal halides, on the other hand, can lead to the formation of metal films on the optical components of the laser unit due to photochemical processes caused by the laser radiation itself and this again is very detrimental to the performance of the laser. Moreover, the reaction products generated by the chemical reactions of the erosion products with the laser gas contaminate the laser gas. This leads to shorter operating time for the laser gas and thus increases maintenance work.

The material making up the electrodes, therefore, is decisive for the service life of the electrodes whose shape and gas discharge gap between each other changes in an undesired way due to erosion. The electrode material is also decisive for the lifetime of the laser gas and the laser optical system.

Several efforts have been made to find a suitable electrode material for gas discharge lasers.

US patent 5729565 discloses a high pressure excimer laser having a pair of electrodes made from a substantially non-oxidized and uncoated material selected from the group consisting of zirconium, yttrium, hafnium, lanthanum and alloys thereof in order to enable operation of the electrodes made from these materials together with laser gases containing fluorine or chlorine. However, these materials are very expensive.

In order to obtain low erosion of the electrode material, US patent 5347532 discloses making the electrodes of an excimer laser from metallic materials having different standard potentials, wherein one electrode consists substantially of copper.

However, copper has many disadvantages when being used in an excimer laser. For example the melting point. of copper is very low leading to a marked erosion of the electrodes.

In addition, the highly reactive excimer gas, which preferably comprises a mixture of halogens and noble gases, used for generating light emission, strongly reacts with the copper of the electrodes. This leads to contamination of the laser gas which in turn shortens the operating time of the laser gas. On the other hand, shortened operating time of the laser gas causes intensified maintainence work resulting in opening the laser tube. However, an opened laser tube allows water contained in the air to enter the laser tube. During operation of the laser, this water leads to formation of strong acids (e.g. HCl) which destroy the electrodes.

### SUMMARY OF THE INVENTION

Thus, a first object of the invention is to provide an electrode material for laser gas discharge electrodes of gas discharge lasers which has a low erosion rate and causes only minimal contamination of the gas within the laser tube, and gives rise to minimal dust.

To achieve the first object, a compound material comprising tungsten and rhodium or tungsten and a mixture of nickel and iron is provided as the electrode material, wherein the amount of tungsten exceeds the amount of rhodium or the amount of said mixture of nickel and iron, respectively.

Tungsten has a very high melting point slightly higher than that of rhodium. A alloy material comprising tungsten and rhodium thus provides an electrode material with very low erosion.

This alloy material is less sensitive to erosion caused by the plasma existing during operation of the gas discharge laser. Thus, less particles are eroded from the electrodes and therefore the gas contained within the laser participates in fewer reactions. Preferably, said electrode material is a sintered material.

Further, the compund material has the advantage that so-called spikes occurring during operation of conventional gas lasers as small pointed elevations on the surface of the discharge electrodes can be prevented.

These spikes occur due to the high temperatures at the surface of the discharge electrodes. In conventional electrodes, these high temperatures cause the electrode material to melt in small particles and to recrystal on the surface of conventional discharge electrodes. However, according to the invention, the alloy constituents in the electrode material also melt due to the high temperatures and serve as a connective material leading to recrystalization of the melted electrode compound materials without causing spike generation.

Preferably, in the case of tungsten and rhodium as compound materials, the melting point of rhodium is slightly lower than that of tungsten. Thus rhodium melts at a slightly lower temperature than tungsten, thereby providing a connective material for the small tungsten particles which may be melted later. This connective material prevents the generation of spikes due to integration of the tungsten particles in the connective material of molten rhodium.

Moreover, less eroded particles result in reduced dust production which would otherwise pollute the optical elements, for example a window of the tube, especially the output window, through which the laser light is emitted, or a mirror, which is provided to form a field of standing waves.

Further, Mg and/or Zn can be provided in the electrode material in order to further improve the maintenance characteristics of the electrode material due to the hygroscopic character of compounds formed from Mg and/or Zn and components of the laser gas during operation of the laser. Providing Mg and/or Zn in the electrode material for discharge electrodes leads to drying of the laser gas during operation of the gas laser. This drying of the laser gas leads to enhanced operating time of the laser gas.

Since the inventive alloy material is less reactive with the gas contained within the tube of the inventive gas discharge laser than with the gas contained, within the tube of a conventional gas discharge laser, less reaction products of the electrode materials and the laser gas are generated. Such products would otherwise contaminate the gas within the laser tube. For this reason, longer operating times are attainable for the gas of the inventive laser system than for the gas of conventional laser systems.

A second object of the invention is to provide a gas laser comprising electrodes which have a very low erosion rate.

To achieve the second object of the invention, a gas laser is provided comprising a housing which defines a cavity for containing laser gas. Additionally, a first electrode and a second electrode are disposed in a spaced relationship relative to one another, thereby defining a discharge region. A further provided laser optic comprises a window, wherein rays of light emit through the window due to a discharge in the discharge region after having been reflected by at least one mirror arranged in the housing. At least the first and/or the second electrode are made from a compound material comprising tungsten and rhodium or tungsten and a mixture of nickel and iron, wherein the amount of tungsten exceeds the amount of rhodium or the amount of said mixture of nickel and iron, respectively.

Preferably, the compound material further comprises Mg and/or Zn in order to improve the operating time intervals due to the hygroscopic effect of compounds formed from Mg and/or Zn with components of the laser gas during operation of the laser.

The inventive compound material can be a sintered material.

The gas discharge laser comprising electrodes made from the electrode material according to the invention has improved maintenance intervals since the operating time of the gas filled in the tube of the gas laser is very long due to the very low erosion rate of the inventive electrode material. This leads to less dust generation and fewer chemical reactions between the electrode material and the gas within the tube of the gas laser. Further, the additional Mg and/or Zn content of the electrode material according to the invention causes drying of the laser gas due to the hygroscopic effect of Mg and/or Zn compounds formed during operation of the laser from the Mg and/or Zn and the components of the laser gas.

Moreover, if the electrode material according to the invention is a sintered material, the generation of hillocks or spikes on the surface of the electrodes due to erosion of the electrodes during operation of the laser is reduced since those compound materials having a lower melting point than other compound materials of the electrode material can melt during erosion of the electrode, whereby the surface of the electrode remains smooth.

### BRIEF DESCRIPTION OF THE DRAWINGS

FIGURE 1 is a longitudinal sectional view of a gas laser according to a preferred embodiment of the invention;
FIGURE 2 is a cross-sectional view of a gas laser according to a preferred embodiment of the invention;

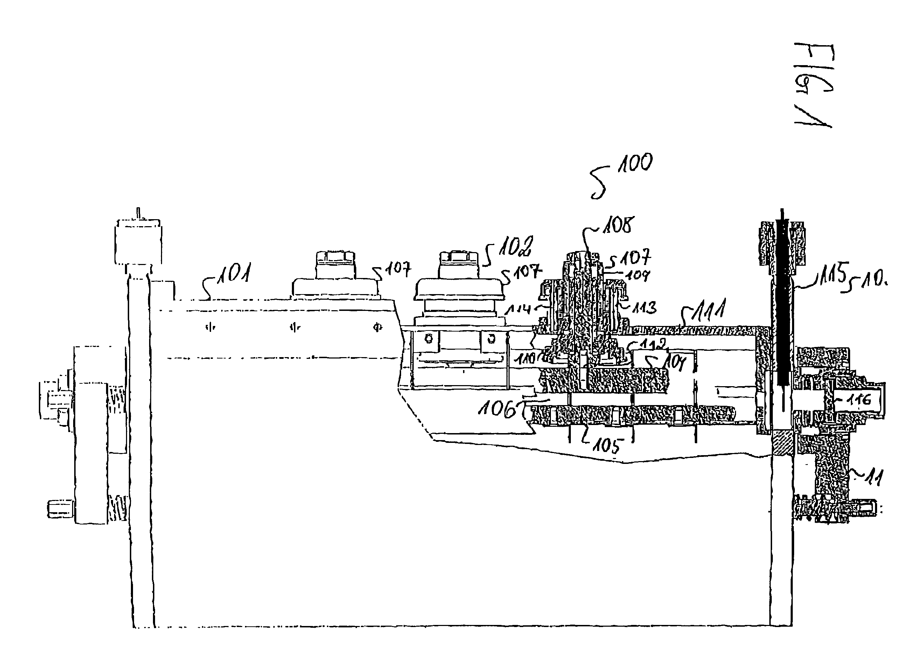

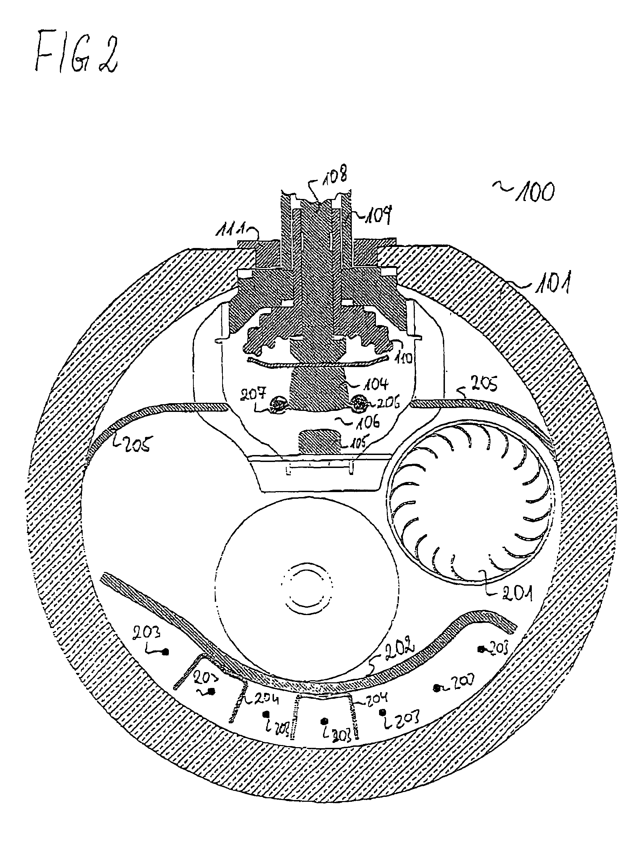

Figure 1 shows a gas laser 100 comprising a tube 101, a discharge unit 102, a fan (as the circulation means) 201 (cf. Figure 2), and a laser optical system 103.

The discharge unit 102 is mounted on the tube 101 and comprises a high voltage electrode 104 and a ground electrode 105. The high voltage electrode 104 and a ground electrode 105 are disposed in spaced relationship relative to one another, thereby defining a discharge gap 106. A high voltage is applied to the high voltage electrode 104 by means of a high voltage supply via a plurality of high voltage ducts 107 supporting the high voltage electrode 104.

Each high voltage duct 107 comprises a conductive core 108 and an insulator element 110 arranged around the conductive core 108. Each high voltage duct 107 is mounted to the high voltage electrode 104 by means of a screw 112.

Furthermore, an electrode plate 111 is provided. The electrode plate 111 comprises holes, through which the high voltage ducts 107 extend so as to connect to the high voltage electrode 104. Each high voltage duct 107 is fixed to the electrode plate 111 by means of screws 113, 114.

The high voltage electrode 104 and the ground electrode 105 preferably comprise 80% tungsten and 20% rhodium. According to another preferred embodiment of the invention, the high voltage electrode 104 and the ground electrode 105 comprise 80% tungsten and 20% of a mixture of one or more of the alloy constituents iron and nickel.

However, it is also possible to form the high voltage electrode 104 and the ground electrode 105 from a material comprising 99.5% tungsten or less and the residual share is rhodium or a mixture of one or more of the alloy constituents iron and nickel.

In another preferred embodiment, the high voltage electrode 104 and the ground electrode 105 are made from a material which comprises 98.5% tungsten and the residual share is rhodium or a mixture of one or more of the alloy constituents iron and nickel.

It is moreover possible to form the high voltage electrode from a material having different proportions of tungsten and rhodium or tungsten and the mixture of one or more of the alloy constituents iron and nickel than the material from which the ground electrode is formed.

Further, it is possible to provide the electrode material with Mg and/or Zn at a concentration of preferably more than 0.1 wt.%. This Mg and/or Zn of the electrode material can chemically react with halogens being used as a component of the laser gas. The reaction of halogens with Mg and/or Zn results in Mg- or Zn- halogen compounds which are strongly hygroscopic. Thus, water contained in the laser gas is sequestered by these Mg- and/or Zn- halogen compounds leading to drying of the laser gas. Further, during the reaction of the Mg- and/or Zn- halogen compounds, the halogen is liberated and can again participate the laser light generating process. By drying the laser gas the operating time of the laser is enhanced.

The insulator elements 110 are made of a ceramic material, optionally a fluoride material. They have a shape which conically expands towards the high voltage electrode 104 and comprises a corrugated surface, so as to increase a creepage path extending along said surface. This helps to prevent arcing between the high voltage electrode 104 and the grounded electrode plate 105.

A fluoride material can be used as insulator material. These materials have the drawback that they are relatively expensive. According to the preferred embodiment of the invention only a small amount of insulator is required, so the use of fluoride materials is rendered affordable and profitable.

The gas laser 100 is a pulsed xenon chloride (XeCl) excimer laser with a wavelength of about 308 nanometers. This means, xenon chloride gas is used for generating a laser beam.

By applying a high voltage pulse of 20 kV to the high voltage electrode 104, the xenon chloride gas in the discharge gap 106 generates a laser beam which is emitted through the laser optical system 103. Preferably, helium and/or neon is provided in the laser tube as a buffer gas.

The laser optical system 103 comprises a dust deposition device 115, a window 116, through which the laser beam emits, and an adjusting means 117 for adjusting the position of the window in relation to the tube 101.

In Figure 2, shows a cross-sectional view of the excimer laser 100. As can be seen in Figure 2, the excimer laser 100 further includes a fan 201 for circulating the xenon chloride gas through the discharging gap 106 and a dedusting unit 202 for dedusting the gas flow through the tube 101. The dedusting unit comprises high voltage wires 203, separated from each other by U-formed plates 204 extending along the tube 101. Furthermore, two elongated guiding plates 205 are provided in longitudinal direction of the tube 101 for guiding the gas flow.

Two pre-ionizers 206, 207 are provided adjacent to the high voltage electrode 104, which two pre-ionizers serve to pre-ionize the laser gas to ensure a larger homogeneity of the gas discharge in the discharge gap 106.

The pre-ionizers 206, 207 are corona-type pre-ionizers and extend substantially parallel to said high voltage electrode. The pre-ionizers 206, 207 have a coaxial shape and each comprise a tube of said insulator. The material of said tubes can be a fluoride as well.

Furthermore, it should be emphasized, that the invention is suitable for any gas laser, though in the preferred embodiment, an excimer laser is described as an example.

As will be understood by those familiar with the art, the present invention may be embodied in other specific forms without departing from the spirit or essential characteristics thereof. Accordingly, the disclosures and descriptions herein are intended to be illustrative, but not limiting, of the scope of the invention which is set forth in the following claims.

## Claims

1. An electrode material for laser gas discharge electrodes (104), (105) for use in a gas discharge laser (100), wherein said electrode material is an alloy comprising tungsten and,
wherein the amount of tungsten exceeds the amount of rhodium.

2. An electrode material for laser gas discharge electrodes (104), (105) for use in a gas discharge laser (100), wherein said electrode material is an alloy comprising tungsten and a mixture of one or more of the alloy constituents nickel and iron,
wherein the amount of tungsten exceeds the amount of the remaining alloy constituents.

3. An electrode material for laser gas discharge electrodes (104), (105) for use in a gas discharge laser (100) according to claim 1, wherein the amount of tungsten is at least 80 wt.% and the rest of the electrode material is rhodium.

4. An electrode material according to claim 3, further comprising Mg and/or Zn.

5. An electrode material according to claim 4, wherein the amount of Mg and/or Zn is more than 0.1 wt.%.

6. An electrode material for laser gas discharge electrodes (104), (105) for use in a gas discharge laser (100) according to claim 1, wherein the amount of tungsten is at least 80 wt.% and the rest of the electrode material is a mixture of one or more of the alloy constituents iron, and nickel.

7. An electrode material according to claim 6, further comprising Mg and/or Zn.

8. An electrode material according to claim 7, wherein the amount of Mg and/or Zn is more than 0.1 wt.%.

9. An electrode material for laser gas discharge electrodes (104), (105) for use in a gas discharge laser (100) according to claim 1, wherein the amount of tungsten is 98.5wt.%.

10. An electrode material for laser gas discharge electrodes (104), (105) for use in a gas discharge laser (100) according to claim 2, wherein the amount of tungsten is 98.5 wt.%.

11. A gas discharge laser system comprising:
a tube (101) containing a gas mixture comprising a laser gas and a buffer gas,
a discharge unit (102) being mountable inside said tube (101) and comprising an elongated high voltage electrode (104) and an elongated ground electrode (105) spaced apart from each other, so as to generate a gas discharge gap (106) between said two electrodes,
a laser optical system (103) for outputting light pulses generated by a gas discharge in said gas discharge gap (106) between said two electrodes (104, 105),
wherein said high voltage electrode (104) and/or said ground electrode (105) comprises an alloy comprising tungsten and rhodium,
wherein the amount of tungsten exceeds the amount of rhodium.

12. A gas discharge laser system comprising:
a tube (101) containing a gas mixture comprising a laser gas and a buffer gas,
a discharge unit (102) being mountable inside said tube (101) and comprising an elongated high voltage electrode (104) and an elongated ground electrode (105) spaced apart from each other, so as to generate a gas discharge gap (106) between said two electrodes (104, 105),
a laser optical system (103) for outputting light pulses generated by a gas discharge in said gas discharge gap (106) between said two electrodes (104, 105),
wherein said high voltage electrode (104) and/or said ground electrode (105) comprises an alloy comprising tungsten and one or more of the alloy constituents nickel and iron,
wherein the amount of tungsten exceeds the amount of the remaining alloy constituents.

13. A gas discharge laser system according to claim 11, wherein the amount of tungsten is at least 80 wt.% and the rest of the electrode material is rhodium.

14. A gas discharge laser system according to claim 12, wherein the amount of tungsten is at least 80 wt.% and the rest of the electrode material is a mixture of one or more of the alloy constituents iron and nickel.

15. A gas discharge laser system according to claim 11, wherein the amount of tungsten is 98.5%.

16. A gas discharge laser system according to claim 11, further comprising Mg and/or Zn.

17. A gas discharge laser system according to claim 16, wherein the amount of Mg and/or Zn is more than 0.1 wt.%.

18. A gas discharge laser system according to claim 12, wherein the amount of tungsten is 98.5%.

19. A gas discharge laser system according to claim 12, further comprising Mg and/or Zn.

20. A gas discharge laser system according to claim 19, wherein the amount of Mg and/or Zn is more than 0.1 wt.%.

21. A gas discharge laser system according to claim 11 further comprising circulation means for providing a gas flow between said two electrodes (104, 105).

22. A gas discharge laser system according to claim 12 further comprising circulation means (205) for providing a gas flow between said two electrodes (104, 105).

23. An excimer laser comprising the gas discharge laser system of claim 11,
wherein said tube (101) containing a gas mixture comprising xenon chloride as a laser gas and helium and/or neon as a buffer gas,
and said laser further comprises a circulation means (201) for providing a gas flow between said two electrodes.

24. An excimer laser comprising the gas discharge laser system of claim 12,
wherein said a tube (101) containing a gas mixture of xenon chloride as a laser gas and helium and/or xenon as a buffer gas,
further comprising circulation means (205) for providing a gas flow between said two electrodes,
a laser optical system (103) for outputting light pulses generated by a gas discharge in said gas discharge gap (106) between said two electrodes (104, 105),
wherein said high voltage electrode (104) and/or said ground electrode (105) comprises an alloy comprising tungsten and one or more of the alloy constituents nickel and iron, wherein the amount of tungsten exceeds the amount of the remaining alloy constituents.

25. An excimer laser according to claim 23, wherein the amount of tungsten is at least 80 wt.% and the rest of the electrode material is rhodium.

26. An excimer laser according to claim 24, wherein the amount of tungsten is at least 80 wt.% and the rest of the electrode material is a mixture of one or more of the alloy constituents iron and nickel.

27. An excimer laser according to claim 23, wherein the amount of tungsten is 98.5%.

28. An excimer laser according to claim 23, further comprising Mg and/or Zn.

29. An excimer laser according to claim 28, wherein the amount of Mg and/or Zn is more than 0.1 wt.%.

30. An excimer laser according to claim 24, wherein the amount of tungsten is 98.5%.

31. An excimer laser according to claim 24, further comprising Mg and/or Zn.

32. An excimer laser according to claim 31, wherein the amount of Mg and/or Zn is more than 0.1 wt.%.

## Patentansprüche

1. Elektrodenmaterial (8) für Laser-Gasentladungs-Elektroden für den Einsatz bei einem Gasentladungs-Laser, bei welchem das Elektrodenmaterial eine Legierung ist, welche Wolfram enthält, und
bei welchem die Menge an Wolfram größer ist als die Menge an Rhodium.

2. Elektrodenmaterial für Laser-Gasentladungs-Elektroden für den Einsatz bei einem Gasentladungs-Laser, bei welchem das Elektrodenmaterial eine Legierung ist, welche Wolfram und ein Gemisch aus einem oder mehreren der Legierungsbestandteile Nickel und Eisen enthält,
bei welchem die Menge an Wolfram größer ist als die Menge der restlichen Legierungsbestandteile.

3. Elektrodenmaterial für Lasar-Gasentladungs-Elektroden für den Einsatz bei einem Gasentladungs-Laser nach Anspruch 1, bei welchem die Menge an Wolfram mindestens 80 Gew.-% beträgt und der übrige Teil des Elektrodenmaterials Rhodium ist.

4. Elektrodenmaterial nach Anspruch 3, welches des weiteren Mg und/oder Zn enthält.

5. Elektrodenmaterial nach Anspruch 4, bei welchem die Menge an Mg und/oder Zn mehr als 0,1 Gew.-% beträgt.

6. Elektrodenmaterial für Laser-Gasentladungs-Elektroden für den Einsatz bei einem Gasentladungs-Laser nach Anspruch 1, bei welchem die Menge an Wolfram mindestens 80 Gew.-% beträgt und der übrige Teil des Elektrodenmaterials ein Gemisch aus einem oder mehreren der Legierungsbestandteile Nickel und Eisen ist.

7. Elektrodenmaterial nach Anspruch 6, welches des weiteren Mg und/oder Zn enthält.

8. Elektrodenmaterial nach Anspruch 7, bei welchem die Menge an Mg und/oder Zn mehr als 0,1 Gew.-% beträgt..

9. Elektrodenmaterial für Laser-Gasentladungs-Elektroden für den Einsatz bei einem Gasentladungs-Laser nach Anspruch 1, bei welchem die Menge an Wolfram 98,5 Gew.-% beträgt.

10. Elektrodenmaterial für Laser-Gasentladungs-Elektroden für den Einsatz bei einem Gasentladungs-Laser nach Anspruch 2, bei welchem die Menge an Wolfram 98,5 Gew.-% beträgt.

11. Gasentladungs-Lasersystem, welches folgendes aufweist:
ein Rohr, das ein Gasgemisch enthält, welches ein Lasergas und ein Puffergas umfasst,
eine Entladungseinheit, welche im Inneren des Rohres montierbar ist und eine lang gestreckte Hochspannungs-Elektrode sowie eine lang gestreckte Erdungselektrode aufweist, wobei die beiden Elektroden so von einander beabstandet sind, dass zwischen den beiden Elektroden ein Gasentladungsspalt entsteht,
ein optisches Lasersystem zum Abgeben von Lichtimpulsen, die in dem Gasentladungsspalt zwischen den beiden Elektroden durch eine Gasentladung erzeugt werden,
wobei die Hochspannungselektrode und/oder die Erdungselektrode eine Legierung aufweist bzw. aufweisen, die Wolfram und Rhodium enthält, und
wobei die Menge an Wolfram größer ist als die Menge an Rhodium.

12. Gasentladungs-Lasersystem, welches folgendes aufweist:
ein Rohr, das ein Gasgemisch enthält, welches ein Lasergas und ein Puffergas umfasst,
eine Entladungseinheit, welche im Inneren des Rohres montierbar ist und eine lang gestreckte Hochspannungs-Elektrode sowie eine lang gestreckte Erdungselektrode aufweist, wobei die beiden Elektroden so von einander beabstandet sind, dass zwischen den beiden Elektroden ein Gasentladungsspalt entsteht,
ein optisches Lasersystem zum Abgeben von Lichtimpulsen, die in dem Gasentladungsspalt zwischen den beiden Elektroden durch eine Gasentladung erzeugt werden,
wobei die Hochspannungselektrode und/oder die Erdungselektrode eine Legierung aufweist bzw. aufweisen, die Wolfram und eines oder mehrere der Legierungsbestandteile Nickel und Eisen enthält, und
wobei die Menge an Wolfram größer ist als die Menge der übrigen Legierungsbestandteile.

13. Gasentladungs-Lasersystem nach Anspruch 11, bei welchem die Menge an Wolfram mindestens 80 Gew.-% beträgt und der übrige Teil des Elektrodenmaterials Rhodium ist.

14. Gasentladungs-Lasersystem nach Anspruch 11, bei welchem die Menge an Wolfram mindestens 80 Gew.-% enthält und der übrige Teil des Elektrodenmaterials ein Gemisch aus einem oder mehreren der Legierungsbestandteile Eisen und Nickel ist.

15. Gasentladungs-Lasersystem nach Anspruch 11, bei welchem die Menge an Wolfram 98,5 % beträgt.

16. Gasentladungs-Lasersystem nach Anspruch 11, welches des Weiteren Mg und/oder Zn aufweist.

17. Gasentladungs-Lasersystem nach Anspruch 16, bei welchem die Menge an Mg und/oder Zn mehr als 0,1 Gew.-% beträgt.

18. Gasentladungs-Lasersystem nach Anspruch 12, bei welchem die Menge an Wolfram 98,5 % beträgt.

19. Gasentladungs-Lasersystem nach Anspruch 12, welches des weiteren Mg und/oder Zn enthält.

20. Gasentladungs-Lasersystem nach Anspruch 19, bei welchem die Menge an Mg und/oder Zn mehr als 0,1 Gew.-% beträgt.

21. Gasentladungs-Lasersystem nach Anspruch 11, welches des Weiteren eine Zirkuliereinrichtung zur Herbeiführung eines Gasstroms zwischen den beiden Elektroden aufweist.

22. Gasentladungs-Lasersystem nach Anspruch 12, welches außerdem eine Zirkuliereinrichtung zur Herbeiführung eines Gasstroms zwischen den beiden Elektroden aufweist.

23. Excimer-Laser, welcher folgendes aufweist:
ein Rohr, das ein Gasgemisch enthält, welches Xenonchlorid als Lasergas und Helium und/oder Neon als Puffergas umfasst,
eine Entladungseinheit, welche im Inneren des Rohres montierbar ist und eine lang gestreckte Hochspannungs-Elektrode sowie eine lang gestreckte Erdungselektrode aufweist, wobei die beiden Elektroden so von einander beabstandet sind, dass zwischen den beiden Elektroden ein Gasentladungsspalt entsteht,
eine Zirkuliereinrichtung zum Herbeiführen eines Gasstroms zwischen den beiden Elektroden,
ein optisches Lasersystem zum Abgeben von Lichtimpulsen, die von einer Gasentladung in dem Gasentladungsspalt zwischen den beiden Elektroden erzeugt werden,
wobei die Hochspannungselektrode und/oder die Erdungselektrode eine Legierung aufweist bzw. aufweisen, die Wolfram und Rhodium enthält, und
wobei die Menge an Wolfram größer ist als die Menge an Rhodium.

24. Excimer-Laser, welcher folgendes aufweist:
ein Rohr, das ein Gasgemisch aus Xenonchlorid als Lasergas und Helium und/oder Neon als Puffergas enthält,
eine Entladungseinheit, welche im Inneren des Rohres montierbar ist und eine lang gestreckte Hochspannungs-Elektrode sowie eine lang gestreckte Erdungselektrode aufweist, wobei die beiden Elektroden so von einander beabstandet sind, dass zwischen den beiden Elektroden ein Gasentladungsspalt entsteht,
eine Zirkuliereinrichtung zum Herbeiführen eines Gasstroms zwischen den beiden Elektroden,
ein optisches Lasersystem zum Abgeben von Lichtimpulsen, die von einer Gasentladung in dem Gasentladungsspalt zwischen den beiden Elektroden erzeugt werden,
wobei die Hochspannungselektrode und/oder die Erdungselektrode eine Legierung aufweist bzw. aufweisen, die Wolfram und eines oder mehrere der Legierungsbestandteile Nickel und Eisen enthält, und wobei die Menge an Wolfram größer ist als die Menge der übrigen Legierungsbestandteile.

25. Excimer-Laser nach Anspruch 23, bei welchem die Menge an Wolfram mindestens 80 % beträgt und der übrige Teil des Elektrodenmaterials Rhodium ist.

26. Excimer-Laser nach Anspruch 24, bei welchem die Menge an Wolfram mindestens 80 Gew.-% beträgt und der übrige Teil des Elektrodenmaterials ein Gemisch aus einem oder mehreren der Legierungsbestandteile Eisen und Nickel ist.

27. Excimer-Laser nach Anspruch 23, bei welchem die Menge an Wolfram 98,5 % beträgt.

28. Excimer-Laser nach Anspruch 23, welcher des weiteren Mg und/oder Zn enthält.

29. Excimer-Laser nach Anspruch 28, bei welchem die Menge an Mg und/oder Zn mehr als 0,1 Gew.-% beträgt.

30. Excimer-Laser nach Anspruch 24, bei welchem die Menge an Wolfram 98,5 % beträgt.

31. Excimer-Laser nach Anspruch 24, welcher des weiteren Mg und/oder Zn enthält.

32. Excimer-Laser nach Anspruch 31, bei welchem die Menge an Mg und/oder Zn mehr als 0,1 Gew.-% beträgt.

## Revendications

1. Matériau d'électrode (8) pour des électrodes de laser à gaz pour l'emploi dans un laser à gaz, dans lequel le matériau d'électrode est un alliage contenant du tungstène, et
dans lequel la quantité de tungstène est plus grande que la quantité de rhodium.

2. Matériau d'électrode pour des électrodes de laser à gaz pour l'emploi dans un laser à gaz, dans lequel le matériau d'électrode est un alliage contenant du tungstène et un mélange d'un ou plusieurs de nickel et du fer en tant que composants d'alliage,
dans lequel la quantité de tungstène est plus grande que la quantité des autres composants d'alliage.

3. Matériau d'électrode pour des électrodes de laser à gaz pour l'emploi dans un laser à gaz selon la revendication 1, dans lequel la quantité de tungstène correspond au moins à 80 % en poids et la fraction restante du matériau d'électrode est de rhodium.

4. Matériau d'électrode selon la revendication 3, qui contient au plus du Mg et/ou du Zn.

5. Matériau d'électrode selon la revendication 4, dans lequel la quantité de Mg et/ou Zn est plus grande que 0,1 % en poids.

6. Matériau d'électrode pour des électrodes de laser à gaz pour l'emploi dans un laser à gaz selon la revendication 1, dans lequel la quantité de tungstène correspond au moins à 80 % en poids et la fraction restante du matériau d'électrode est un mélange d'un ou plusieurs de nickel et du fer en tant que composants d'alliage.

7. Matériau d'électrode selon la revendication 6, qui contient au plus du Mg et/ou du Zn.

8. Matériau d'électrode selon la revendication 7, dans lequel la quantité de Mg et/ou Zn est plus grande que 0,1 % en poids.

9. Matériau d'électrode pour des électrodes de laser à gaz pour l'emploi dans un laser à gaz selon la revendication 1, dans lequel la quantité du tungstène correspond à 98,5 % en poids.

10. Matériau d'électrode pour des électrodes de laser à gaz pour l'emploi dans un laser à gaz selon la revendication 2, dans lequel la quantité du tungstène correspond à 98,5 % en poids.

11. Système de laser à gaz, qui comprend:
un tube qui contient un mélange gazeux comprenant un gaz de laser et un gaz tampon,
une unité de décharge apte à être montée à l'intérieur dudit tube et comprenant une électrode allongée à haute tension ainsi qu'une électrode allongée de mise à la terre, lesdites deux électrodes étant écartées l'une de l'autre par une telle distance, qu'un espace de décharge de gaz soit créé entre lesdites deux électrodes,
un système de laser optique à émettre des impulsions de lumière, qui sont engendrées par une décharge gazeuse dans l'espace de décharge gazeuse entre lesdites deux électrodes,
ladite électrode à haute tension et/ou ladite électrode de mise à la terre comprenant un alliage contenant du tungstène et du rhodium, et
la quantité de tungstène étant plus grande que la quantité de rhodium.

12. Système de laser à gaz, qui comprend:
un tube qui contient un mélange gazeux d'un gaz de laser et d'un gaz tampon,
une unité de décharge apte à être montée à l'intérieur dudit tube et comprenant une électrode allongée à haute tension ainsi qu'une électrode allongée de mise à la terre, lesdites deux électrodes étant écartées l'une de l'autre par une telle distance, qu'un espace de décharge de gaz soit créé entre lesdites deux électrodes,
un système de laser optique à émettre des impulsions de lumière, qui sont engendrées par une décharge gazeuse dans l'espace de décharge gazeuse entre lesdites deux électrodes,
ladite électrode à haute tension et/ou ladite électrode de mise à la terre comprenant un alliage contenant du tungstène et un ou plusieurs de nickel et de fer comme composants d'alliage, et
la quantité de tungstène étant plus grande que la quantité des autres composants d'alliage.

13. Système de laser à gaz selon la revendication 11, dans lequel la quantité de tungstène correspond au moins à 80 % en poids et la fraction restante du matériau d'électrode est de rhodium.

14. Système de laser à gaz selon la revendication 12, dans lequel la quantité de tungstène correspond au moins à 80 % en poids et la fraction restante du matériau d'électrode est un mélange d'un ou plusieurs de fer et de nickel comme des composants d'alliage.

15. Système de laser à gaz selon la revendication 11, dans lequel la quantité de tungstène correspond à 98,5 %.

16. Système de laser à gaz selon la revendication 11, qui comprend au plus du Mg et/ou du Zn.

17. Système de laser à gaz selon la revendication 16, dans lequel la quantité de Mg et/ou Zn est plus grande que 0,1 % en poids.

18. Système de laser à gaz selon la revendication 12, dans lequel la quantité de tungstène correspond à 98,5 %.

19. Système de laser à gaz selon la revendication 12, qui contient au plus du Mg et/ou du Zn.

20. Système de laser à gaz selon la revendication 19, dans lequel la quantité de Mg et/ou Zn est plus grande que 0,1 % en poids.

21. Système de laser à gaz selon la revendication 11, qui comprend en outre un moyen circulatoire à établir un courant de gaz entre lesdites deux électrodes.

22. Système de laser à gaz selon la revendication 12, qui comprend en outre un moyen circulatoire à établir un courant de gaz entre lesdites deux électrodes.

23. Laser dit excimer, qui comprend:
un tube qui contient un mélange gazeux comprenant du chlorure de xénon en tant que gaz de laser et du hélium et/ou du néon en tant que gaz tampon,
une unité de décharge apte à être montée à l'intérieur dudit tube et comprenant une électrode allongée à haute tension ainsi qu'une électrode allongée de mise à la terre, lesdites deux électrodes étant écartées l'une de l'autre par une telle distance, qu'un espace de décharge de gaz soit créé entre lesdites deux électrodes,
un moyen circulatoire à établir un courant de gaz entre lesdites deux électrodes,
un système laser optique à émettre des impulsions de lumière, qui sont engendrées par une décharge gazeuse dans l'espace de décharge entre lesdites deux électrodes,
ladite électrode à haute tension et/ou ladite électrode de mise à la terre comprenant un alliage contenant du tungstène et du rhodium, et
la quantité de tungstène étant plus grande que la quantité de rhodium.

24. Laser dit excimer, qui comprend:
un tube contenant un mélange gazeux de chlorure de xénon en tant que le gaz de laser et/ou de néon en tant que gaz tampon,
une unité de décharge apte à être montée à l'intérieur dudit tube et comprenant une électrode allongée à haute tension ainsi qu'une électrode allongée de mise à la terre, lesdites deux électrodes étant écartées l'une de l'autre par une telle distance, qu'un espace de décharge de gaz soit créé entre lesdites deux électrodes,
un moyen circulatoire à établir un courant de gaz entre lesdites deux électrodes,
un système laser optique à émettre des impulsions de lumière, qui sont engendrées par une décharge gazeuse dans l'espace de décharge entre lesdites deux électrodes,
ladite électrode à haute tension et/ou ladite électrode de mise à la terre comprenant un alliage contenant du tungstène et un ou plusieurs de nickel et de fer comme composants d'alliage, et la quantité de tungstène étant plus grande que la quantité des autres composants d'alliage.

25. Laser dit excimer selon la revendication 23, dans lequel la quantité de tungstène correspond au moins à 80 % et la fraction restante du matériau d'électrode est de rhodium.

26. Laser dit excimer selon la revendication 24, dans lequel la quantité de tungstène correspond au moins à 80 % en poids et la fraction restante du matériau d'électrode est un mélange d'un ou plusieurs de fer et de nickel comme des composants d'alliage.

27. Laser dit excimer selon la revendication 23, dans lequel la quantité de tungstène correspond à 98,5 %.

28. Laser dit excimer selon la revendication 23, qui contient au plus de Mg et/ou Zn.

29. Laser dit excimer selon la revendication 28, dans lequel la quantité de Mg et/ou Zn est plus grande que 0,1 % en poids.

30. Laser dit excimer selon la revendication 24, dans lequel la quantité de tungstène correspond à 98,5 %.

31. Laser dit excimer selon la revendication 24, qui contient au plus de Mg et/ou Zn.

32. Laser dit excimer selon la revendication 31, dans lequel la quantité de Mg et/ou Zn est plus grande que 0,1 % en poids.
